# EUROPÄISCHE PATENTSCHRIFT

(11) **EP 1 815 592 B1**
(45) Veröffentlichungstag und Bekanntmachung des Hinweises auf die Patenterteilung: **21.01.2009**
(21) Anmeldenummer: 05815172.1
(22) Anmeldetag: 15.11.2005
(51) Int. Cl.: H03F 1/32, H04L 27/36

(54) **Verfahren und System zur Ermittlung der Amplitude und/oder Phase des Ausgangssignals eines Übertragungsgliedes in Abhängigkeit der Amplitude des Eingangssignals**
Method and system for detemining the amplitude and/or phase of the output signal of a transmission link according to the amplitude of the input signal
Procédé et système pour determiner l'amplitude et/ou la phase du signal de sortie d'un chainon de voie de transmission en fonction de l'amplitude du signal d'entrée

(30) Priorität: 26.11.2004 DE 102004057189; 17.01.2005 DE 102005002207
(43) Veröffentlichungstag der Anmeldung: 08.08.2007
(73) Patentinhaber: Rohde & Schwarz GmbH & Co. KG, 81671 München (DE)
(72) Erfinder: PLAUMANN, Ralf, 85659 Forstern (DE); LORENZEN, Rolf, 82008 Unterhaching (DE)
(74) Vertreter: Körfer, Thomas
(86) Internationale Anmeldenummer: PCT/EP2005/012264
(87) Internationale Veröffentlichungsnummer: WO 2006/056344

(56) Entgegenhaltungen:
- WO-A-03/043182
- US-A1- 2002 168 023

## Beschreibung

Die Erfindung betrifft ein Verfahren und ein System zur Ermittlung der Amplitude und/oder Phase des Ausgangssignals eines Übertragungsgliedes in Abhängigkeit der Amplitude des Eingangssignals (AM-AM- und AM-PM-Kennlinie).

Nachrichtentechnische Übertragungsglieder, beispielsweise Verstärker in der Empfangs- oder Sende-Einheit eines Mobilfunkgeräts, weisen ein nichtlineares Übertragungsverhalten auf. Dieses nichtlineare Übertragungsverhalten führt zu unerwünschten Amplituden- und Phasenverzerrungen des zu verstärkenden Signals. Zur Kompensation dieser unerwünschten Verzerrungseffekte wird bekannterweise in Serie zum nichtlinearen Übertragungsglied ein Entzerrungsnetzwerk geschaltet, dessen Kennlinie idealerweise invers zur nichtlinearen Übertragungskennlinie des Übertragungsgliedes ausgeprägt ist.

Für die Auslegung der Kennlinie des Entzerrungsnetzwerks wird folglich die Amplitude und Phase des Ausgangssignals des Übertragungsgliedes in Abhängigkeit der Amplitude des Eingangssignals (AM-AM- und AM-PM-Kennlinie) benötigt. Die Bestimmung der Amplituden-Kennlinie des Übertragungsgliedes ergibt sich aus dem funktionalen Zusammenhang der Amplitude bzw. der Leistung des Signals am Ausgang des Übertragungsgliedes in Abhängigkeit von der Amplitude bzw. der Leistung des korrespondierenden Signals am Eingang des Übertragungsgliedes in einem definierten Amplituden- bzw. Leistungsbereich des Signals am Eingang des Übertragungsgliedes. Die Phasen-Kennlinie des Übertragungsgliedes wiederum stellt den funktionalen Zusammenhang der Phasenänderung des Signals zwischen Ausgang und Eingang des Übertragungsgliedes in Abhängigkeit von der Amplitude bzw. Leistung des Signals am Eingang des Übertragungsgliedes in einem definierten Amplituden- bzw. Leistungsbereich des Signals am Eingang des Übertragungsgliedes dar.

In der WO 99/05784 A1 ist ein Verfahren und eine Vorrichtung zur Messung der Amplituden- und Phasenverzerrung eines Hochfrequenz-Leistungsverstärkers beschrieben. Über Synchrondemodulatoren wird hierbei jeweils das Signal am Eingang und am Ausgang des Hochfrequenz-Leistungserstärkers gemessen. Zur Darstellung der Amplitudenkennlinie wird das Verhältnis der Eingangs- zur Ausgangsamplitude bzw. -leistung ermittelt, während zur Darstellung der Phasenkennlinie aus der Inphase- und Quadraturkomponente des Ausgangssignals der zur jeweiligen Amplitude bzw. Leistung des Signals am Eingang gehörige Phasenwert ermittelt wird. Durch Vorgabe eines bestimmten Signalverlaufs am Eingang des Hochfrequenz-Leistungsverstärkers mittels Signalgenerator wird der gesamte Verlauf der Amplituden- und Phasenkennlinie bestimmt. Die Synchronisierung zwischen dem Signal am Eingang und am Ausgang des Hochfrequenz-Leistungsverstärkers erfolgt über ein Referenzträgersignal zwischen den einzelnen Synchrondemodulatoren.

Bei der Kalibrierung von Leistungsverstärkern in Empfangs- und/oder Sende-Einheiten von Mobilfunkgeräten ist die in der WO 99/05784 A1 beschriebene Vorgehensweise der Messung zweier Signale - am Eingang und am Ausgang des Leistungsverstärkers - und der zusätzlich nötigen Synchronisierung der beiden Signale zu zeit- und gleichzeitig zu funktionsaufwendig.

Ein ähnliches Verfahren und ähnliche Vorrichtung sind auch in der WO 03/043182 beschrieben.

Der Erfindung liegt deshalb die Aufgabe zugrunde, ein Verfahren und ein System zur Ermittlung der Amplitude und/oder Phase des Ausgangssignals eines Übertragungsgliedes in Abhängigkeit der Amplitude des Eingangssignals zu schaffen, das im Hinblick auf minimale Prozeßzeit und maximale Prozeßsicherheit optimiert ist.

Die Aufgabe der Erfindung wird durch ein Verfahren zur Ermittlung der Amplitude- und/oder Phase des Ausgangssignals eines Übertragungsgliedes in Abhängigkeit der Amplitude des Engangssignals mit den Merkmalen nach Anspruch 1 und durch ein System zur Ermittlung der Amplitude- und/oder Phase des Ausgangssignals eines Übertragungsgliedes in Abhängigkeit der Amplitude des Eingangssignals mit den Merkmalen nach Anspruch 10 gelöst. Vorteilhafte Weiterbildungen der Erfindung sind in den abhängigen Ansprüchen aufgeführt.

Beim erfindungsgemäßen Verfahren und beim erfindungsgemäßen System zur Ermittlung der Amplitude- und/oder Phase des Ausgangssignals eines Übertragungsgliedes in Abhängigkeit der Amplitude des Eingangssignals wird erfindungsgemäß nur noch das Signal am Ausgang des Übertragungsgliedes gemessen. Das Signal, das am Eingang des Übertragungsgliedes eingeprägt und nicht mehr gemessen wird, muß folglich bekannt sein und sollte im Hinblick auf die Ermittlung der Amplituden- und Phasen-Kennlinie des Übertragungsgliedes einzig durch das Übertragungsglied hinsichtlich seiner Amplitude und Phase verzerrt werden. Die erste Bedingung wird erreicht, indem vom Anwender über eine Einheit zur übergeordneten Ablaufsteuerung einer Sende-Einheit zur Erzeugung des Signals am Eingang des Übertragungsgliedes ein bekanntes Testsignal vorgegeben wird. Die zweite Bedingung wird durch eine meß- und schaltungstechnische Anordnung verwirklicht, die zusätzliche Amplituden- und Phasenverzerrungen in Signalpfad garantiert vermeidet.

Die fehlende Zeit-, Frequenz- und Phasensynchronisierung zwischen dem Testsignal am Eingang des Übertragungsgliedes und dem aus dem Testsignal durch Amplituden- und Phasenverzerrung im Übertragungsglied hervorgegangenen Antwortsignal am Ausgang des Übertragungsgliedes wird vorzugsweise über eine Schätzung des Zeit-, Frequenz- und Phasenversatzes aus dem Antwortsignal gewonnen. Hierzu wird das Testsignal und damit das vom Testsignal abhängige Antwortsignal in einen ersten und einen zweiten Signalabschnitt unterteilt.

Im ersten Signalabschnitt I erfolgt die Ermittlung des Zeitversatzes zwischen Test- und Antwortsignal und darauf aufbauend die Bestimmung des Startzeitpunktes des zweiten Signalabschnitts II. Zusätzlich wird im Signalabschnitt I der Frequenzversatz des Trägersignals zwischen Eingang und Ausgang des Übertragungsgliedes bestimmt.

Im zweiten Signalabschnitt II erfolgt die eigentliche Ermittlung der Amplituden- und Phasen-Charakteristik des Übertragungsgliedes auf der Basis der im Signalabschnitt I ermittelten Bezugsgrößen:
- Startzeitpunkt des Signalabschnitts II,
- Phase des Antwortsignals im Startzeitpunkt in Relation zu einer Bezugsphase und
- Frequenzversatz des Trägersignals zwischen Eingang und Ausgang des Übertragungsgliedes.

Für den ersten Signalabschnitt I wird, auch im Hinblick auf die Ermittlung der Amplituden- und Phasen-Kennlinie eines Leistungsverstärker in der Empfangs- und Sende-Einheit eines Mobilfunkgeräts, beispielsweise ein GSM-Burstsignal verwendet. Über eine Modulations-Analyse, die zum Stand der Technik zählt, wird auf der Basis einer Test-Symbolsequenz des GSM-Burstsignals der Zeit- und Frequenzversatz geschätzt.

Der zweite Signalabschnitt II kann einen beliebigen Signalverlauf aufweisen. Im Hinblick auf eine zeiteffiziente Kalibrierung des gesamten Pegelbereichs ist aber ein rampenförmiger Amplitudenverlauf vorteilhaft, der beginnend beim GSM-Burstsignalpegel als maximal zu kalibrierender Amplitudenpegel bis zum minimal zu kalibrierenden Amplitudenpegel abfällt. Der Phasenverlauf sollte der Einfachheit wegen konstant ausgelegt werden.

Zur Minimierung des Rauschanteils bei der Bestimmung der Amplituden- und Phasen-Kennlinie des Übertragungsgliedes wird das Übertragungsglied nicht nur einmalig mit einem Testsignal mit obiger Signalausprägung beaufschlagt, sondern kann mehrmalig mit einem identischen Testsignal angeregt und der jeweils am Ausgang des Übertragungsglieds gemessene Antwortsignalverlauf einer Mittelung zugeführt werden. Im Hinblick auf eine kohärente Mittelung wird die im Signalabschnitt I jeweils ermittelte Phase des Antwortsignals im Startzeitpunkt des Signalabschnitts II zu einer festgelegten Bezugsphase referenziert und mittels Referenzierung zur Bezugsphase die einzelnen Antwortsignale zueinander phasensynchron gemittelt.

Aus dem jeweils im Meßgerät gemittelten Amplituden- und Phasenverlauf des Antwortsignals und dem vorab festgelegten Amplituden- und Phasenverlauf des Testsignals wird vorzugsweise in einer Einheit zur übergeordneten Ablaufsteuerung die für das Übertragungsglied bestimmende Amplituden- und Phasen-Charakteristik ermittelt.

Eine Ausführungsform des erfindungsgemäßen Verfahrens zur Messung der Amplituden- und Phasen-Charakteristik eines Übertragungsgliedes und des erfindungsgemäßen Systems zur Messung der Amplituden- und Phasen-Charakteristik eines Übertragungsgliedes wird im folgenden unter Berücksichtigung der Zeichnung näher erläutert. In der Zeichnung zeigen:
- Fig. 1: ein Blockschaltbild eines zu kalibrierenden Polar-Modulators für ein Mobilfunkgerät,
- Fig. 2: ein Blockschaltbild eines erfindungsgemäßen Systems zur Messung der Amplituden- und Phasen-Charakteristik eines Übertragungsgliedes,
- Fig. 3: ein Flußdiagramm eines erfindungsgemäßen Verfahrens zur Messung der Amplituden- und Phasen-Charakteristik eines Übertragungsgliedes,
- Fig. 4: ein Zeitdiagramm des Amplituden- und Phasenverlaufs des Test- und Antwortsignals und
- Fig. 5: eine Symbolfolgenstruktur eines GSM-basierten Testsignals.

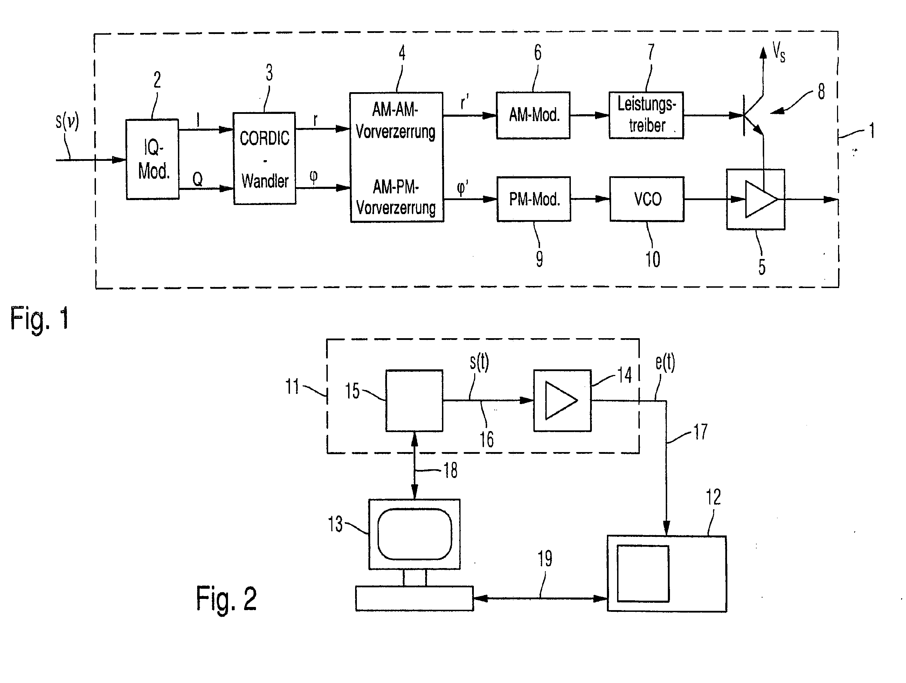

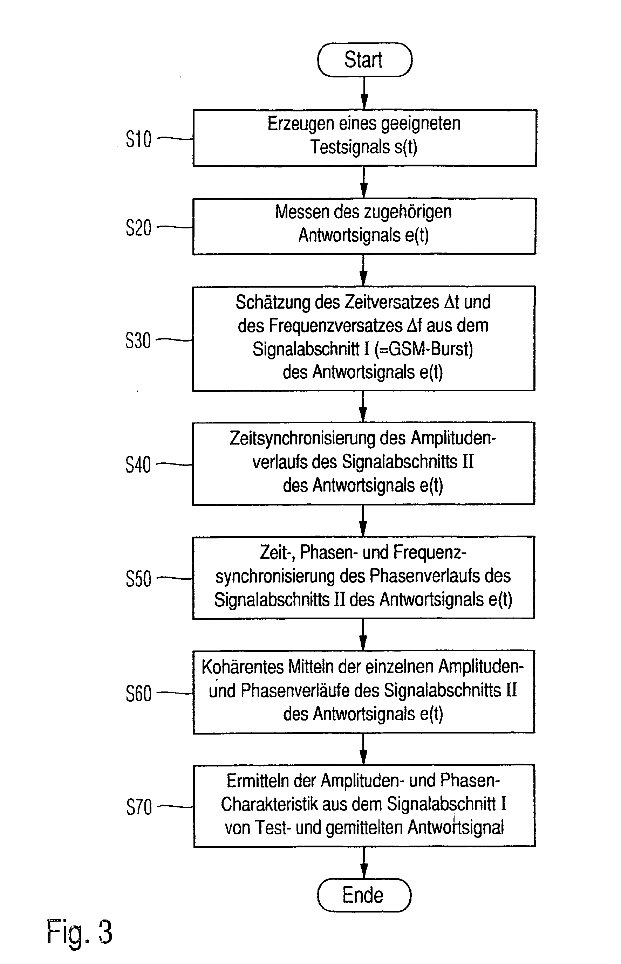

Bevor anhand von Fig. 2 und Fig. 3 das erfindungsgemäße System und das erfindungsgemäße Verfahren zur Ermittlung der Amplituden- und Phasen-Charakteristik eines allgemeinen Übertragungsgliedes beschrieben wird, wird zuerst anhand von Fig. 1 die Struktur und Funktionsweise eines Polar-Modulators für ein Mobilfunkgerät vorgestellt, dessen Kalibrierung als bevorzugter Anwendungsfall des erfindungsgemäßen Verfahrens und erfindungsgemäßen Systems zur Ermittlung der Amplituden- und Phasen-Kennlinie eines Übertragungsgliedes gilt.

Der Polar-Modulator 1 wird von einer Signalquelle, die in Fig. 1 nicht dargestellt ist, mit einer zu übertragenden Symbolfolge s(v) beaufschlagt. Ein IQ-Modulator 2 erzeugt aus der Symbolfolge s(v) mit Hilfe eines Trägersignals die Inphase- und Quadratur-Komponente I und Q eines vom Mobilfunkgerät zu sendenden Quadratursignals. Über einen CORDIC-Wandler 3 erfolgt eine Konvertierung der Inphase- und Quadratur-Komponente I und Q des Quadratursignals in dazu korrespondierende Amplituden- und Phasenkomponenten r und ϕ des zu übertragenden Signals.

In einer nachfolgenden Vorverzerrungs-Einheit 4 erfolgt eine getrennte Vorverzerrung der Amplituden-Komponente r und der Phasen-Komponente ϕ. Durch die Vorverzerrung wird eine im nachfolgenden Leistungsverstärker 5 verursachte Amplituden- und Phasenverzerrung des zu übertragenden Signals kompensiert und somit ein zu übertragendes Signal im Polar-Modulator 1 erzeugt, das idealerweise keine Amplituden- und Phasen-Verzerrung aufweist.

Die vorverzerrte Amplituden-Komponente r' wird anschließend in einem Amplituden-Modulator 6 im wesentlichen über einen multiplizierenden Digital-AnalogWandler in den für die Ansteuerung eines nachfolgenden Leistungstreibers 7 erforderlichen Pegelbereich gewandelt. Der Leistungstreiber 7 steuert einen Leistungstransistor 8 an, der von einer Spannungsquelle V_{S} versorgt wird und als externe Leistungsendstufe des Leistungsverstärkers 5 dient.

Parallel zum Amplituden-Modulationspfad wird die vorverzerrte Phasen-Komponente ϕ' einem Phasen-Modulator 9 in einem Phasen-Modulationspfad zugeführt. Der Phasen-Modulator 9 erzeugt aus der Phasen-Komponente ϕ' ein Signal, das der Frequenz der über der Zeit rotierenden Phasen-Komponente ϕ' entspricht und als Frequenz-Sollwert für einen nachfolgenden spannungsgesteuerten Frequenzoszillator (VCO) 10 dient. Das vom spannungsgesteuerten Frequenzoszillator 10 erzeugte Frequenzsignal wird dem Leistungsverstärker 5 zugeführt und hinsichtlich seiner Amplitude in dem als Leistungsendstufe dienenden Leistungstransistor 8 verstärkt und am Ausgang des Leistungsverstärkers 5 zu der Antenne des Mobilfunkgeräts weitergeleitet.

Für die Vorverzerrung der Amplituden-Komponente r und der Phasen-Komponente ϕ des zu sendenden Signals in der Vorverzerrungs-Einheit 4 ist die Amplituden-Vorverzerrungskennlinie (AM-AM-Vorverzerrungskennlinie) und die Phasen-Vorverzerrungskennlinie (AM-PM-Vorverzerrungskennlinie) zu ermitteln, die bei idealer Vorverzerrung jeweils invers zur Amplituden-Verzerrungskennlinie (AM-AM-Verzerrungskennlinie) und Phasen-Verzerrungskennlinie (AM-PM-Verzerrungskennlinie) des Leistungsverstärkers 5 ist. Somit ist für einen verzerrungsfreien Betrieb des Polar-Modulators 1 des Mobilfunkgeräts die Bestimmung der Amplituden- und Phasen-Charakteristik des Leistungsverstärkers 5 im Rahmen eines Kalibrierungsvorgangs des Mobilfunkgeräts zu ermitteln.

Im folgenden wird ausgehend vom einem Leistungs-Verstärker 5 eines Polar-Modulators 1 für ein Mobilfunkgerät gemäß Fig. 1 ein erfindungsgemäßes System zur Ermittlung der Amplituden- und Phasen-Kennlinie eines allgemeinen Übertragungsgliedes in Fig. 2 vorgestellt.

Das erfindungsgemäße System besteht aus einem zu kalibrierenden Meßobjekt (device under test = DUT) 11, das dem Polar-Modulator 1 des Mobilfunkgeräts in Fig. 1 entspricht, einem Meßgerät 12 und einer Einheit zur übergeordneten Ablaufsteuerung 13, die beispielsweise durch einen Personalcomputer realisiert ist. Das zu kalibrierende Meßobjekt (DUT) 11 besteht wiederum aus einem Übertragungsglied 14, das dem Leistungsverstärker 5 des Polar-Modulators 1 in Fig. 1 entspricht, mit einer im allgemeinen nichtlinearen Amplituden- und Phasen-Kennlinie.

Das Übertragungsglied 14 wird von einer Sende-Einheit 15, die in Summe den Funktionseinheiten 2, 3, 4, 6, 7, 8, 9 und 10 des Polar-Modulators 1 in Fig. 1 entspricht, über die unidirektionale Verbindungsleitung 16 mit einem Testsignal s(t) beaufschlagt, das aus einer Amplituden-Komponente |s(t)| und einer Phasen-Komponente ϕ_{S}(t) besteht, und liefert ein entsprechend seiner Amplituden- und Phasen-Kennlinie verzerrtes Antwortsignal e(t), das aus einer Amplituden-Komponente |e(t)| und einer Phasen-Komponente ϕ_{E}(t) besteht, über die unidirektionale Verbindungsleitung 17 an das Meßgerät 12. Die Einheit zu übergeordneten Ablaufsteuerung 13 kommuniziert über die bidirektionale Verbindungsleitung 18 mit der Sende-Einheit 15 und über die bidirektionale Verbindungsleitung 19 mit dem Meßgerät 12.

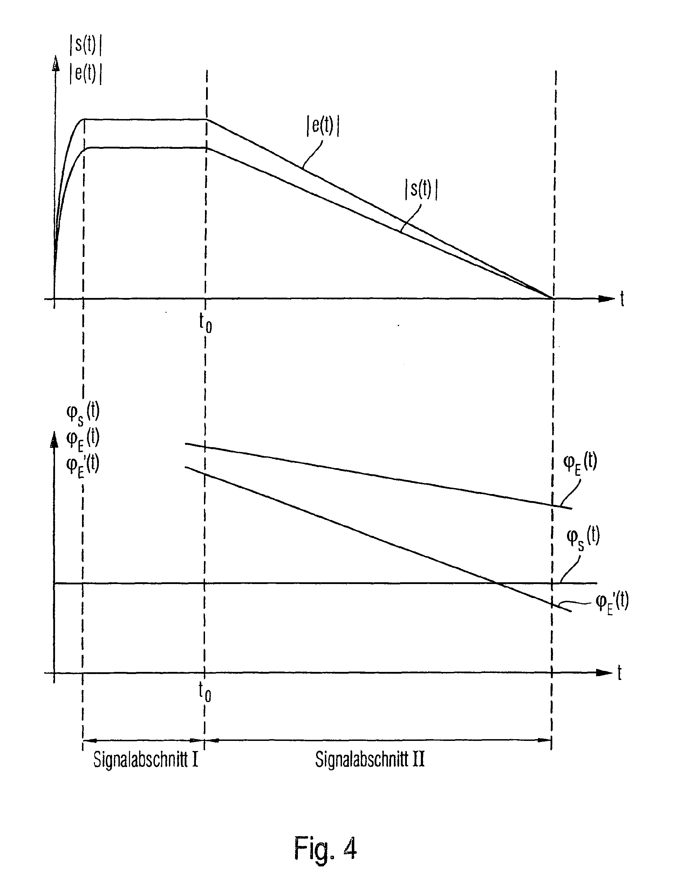

Das erfindungsgemäß bevorzugte Verfahren zur Ermittlung der AM-AM- und des AM-PM-Verhaltens eines Übertragungsgliedes 14 gemäß Fig. 3 beginnt in Verfahrensschritt S10 mit der Erzeugung eines vorher festgelegten Testsignals s(t) durch die Sende-Einheit 15. Das Testsignal s(t) ist prinzipiell gemäß Fig. 4 in einen ersten Signalabschnitt I und in einen zweiten Signalabschnitt II unterteilt.

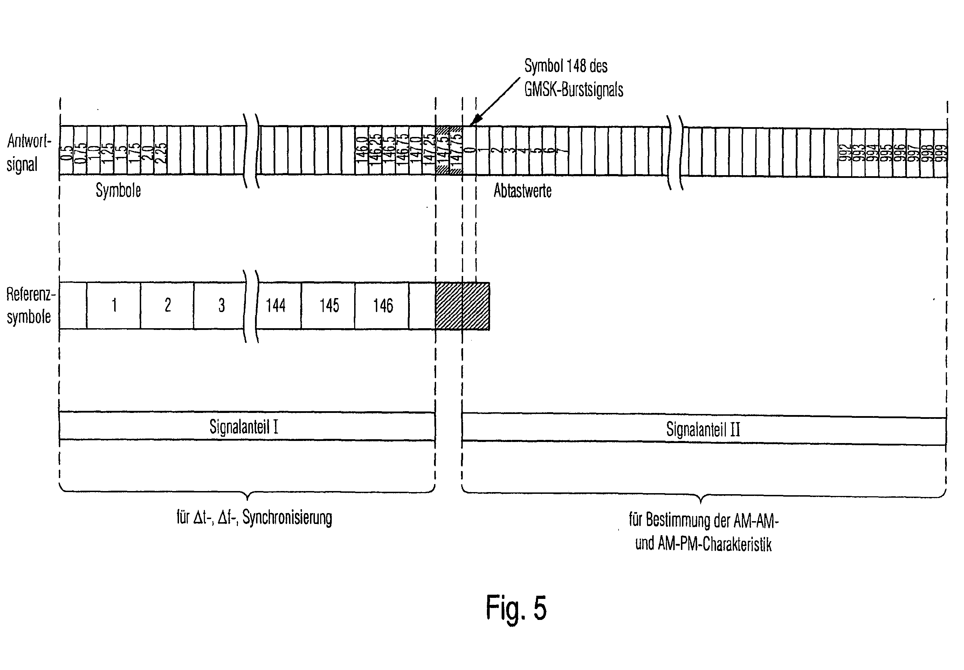

Im ersten Signalabschnitt I wird ein Burst-Signal, im Falle der Kalibrierung eines Mobilfunkgeräts je nach verwendetem Modulations-Standard beispielsweise ein GMSK-, EDGE-, AMPS-, ANSI-136- oder Weitband-CDMA-Burst-Signal, benutzt. Wird beispielsweise ein GMSK-Burstsignal verwendet, so besteht dieses gemäß Fig. 5 aus einer Symbolfolge von standardmäßig insgesamt 148 Symbolen, die mit einer bestimmten standardmäßig festgelegten Abtastrate f_{S} übertragen werden. Innerhalb dieser Symbolfolge von insgesamt 148 Symbolen wird vom GSM-Empfänger eine Modulations-Analyse zur Zeit-, Frequenz- und PhasenSynchronisierung des Empfängers an den Sender durchgeführt.

Im zweiten Signalabschnitt II erfolgt die eigentliche Bestimmung der Amplituden- und Phasencharakteristik des Übertragungsgliedes 14. Hierbei kann ein beliebiger Amplitudenverlauf |s(t)| und Phasenverlauf ϕ_{S}(t) des Testsignals s(t) festgelegt werden. Im Amplitudenverlauf |s(t)| sollten alle Signalpegelwerte des gesamten Eingangssignalbereichs des Übertragungsgliedes 14 zumindest einmal auftreten. Um die Kalibrierzeit des zu kalibrierenden Meßobjekts 11 zu minimieren, ist ein rampenförmiger Amplitudenverlauf |s(t)| im zweiten Signalabschnitt II des Testsignals s(t) bevorzugt, dessen Startamplitudenwert sinnvollerweise in der Nähe des Amplitudenwerts der GSM-Burstsymbolfolge liegt und der bis zum minimalen Amplitudenwert des Eingangssignalbereichs des Übertragungsgliedes 14 rampenförmig abfällt. Der Phasenverlauf ϕ_{S}(t) sollte günstigerweise eine konstanten Verlauf aufweisen.

Das Testsignal s(t) wird infolge der Amplituden- und Phasen-Kennlinie des Übertragungsgliedes 14 verzerrt. Das aus dem Testsignal s(t) durch Amplituden- und Phasenverzerrung hervorgegangene Antwortsignal e(t) am Ausgang des Übertragungsgliedes 14 wird im Verfahrensschritt S20 im ersten Schritt hinsichtlich des Verlauf seiner Inphase- und Quadraturkomponente vom Meßgerät 12 gemessen, woraus im zweiten Schritt der Amplitudenverlauf |e(t)| und Phasenverlauf ϕ_{E}(t) ermittelt wird.

Im darauf folgenden Verfahrensschritt S30 erfolgt durch das Meßgerät 12 die oben erwähnte Modulations-Analyse des im Falle einer Kalibrierung eines Mobilfunkgeräts verwendeten GSM-Burstsignals im ersten Signalabschnitt I des gemessenen Antwortsignals e(t). Die Bestimmung des Zeitversatzes Δt zwischen Testsignal s(t) und Antwortsignal e(t), des Frequenzversatzes Δf des Trägers zwischen Eingang und Ausgang des Übertragungsgliedes 14 und des Phasenversatzes zwischen Testsignal s(t) und Antwortsignal e(t) erfolgt mit bekannten Schätzverfahren, die im wesentlichen auf der Methode der minimalen Fehlerquadrate basieren.

Im nächsten Verfahrensschritt S40 erfolgt durch das Meßgerät 12 die Zeitsynchronisierung des Amplitudenverlaufs |e(t)| des Antwortsignals e(t) im zweiten Signalabschnitt II durch Bestimmung des Startzeitpunkts t₀ des zweiten Signalabschnitts II. Der Startzeitpunkt t₀ des zweiten Signalabschnitts II des Antwortsignals e(t) ergibt sich aus dem zu messenden Start- oder Endzeitpunkt der Trainingssequenz (TSC) und der bekannten Anzahl von Bits zwischen dem Start- oder Endzeitpunkt der Trainingssequenz (TSC) und dem Startzeitpunkt t₀.

Der darauf folgende Verfahrensschritt S50 beinhaltet die Zeit-, Phasen- und Frequenzsynchronisierung des Phasenverlaufes ϕ_{E}(t) des Antwortsignals e(t) im zweiten Signalabschnitts II. Die Zeitsynchronisierung des Phasenverlaufes ϕ_{E}(t) mit Bestimmung des Startzeitpunkt t₀ des zweiten Signalabschnitts II entspricht der Zeitsynchronisierung des Amplitudenverlauf |e(t)| im Verfahrensschritt S40.

Bei der Phasensynchronisierung wird die Phase des Antwortsignals e(t) zur Phase des Testsignals s(t) zum Startzeitpunkt t₀ des zweiten Signalabschnitts II synchronisiert. Da die Phase des Antwortsignals e(t) zum Startzeitpunkt t₀ des zweiten Signalabschnitts II aufgrund der durch die unbekannte Symbolfolge im Signalabschnitt I verursachten AM-PM-Verzerrung zzgl. einer nicht vorhersehbaren durch das Rauschen des Testsignals s(t) verursachten Phasenverzerrung und eines modulationsabhängigen Phasenfehlers im ersten Signalabschnitt I bei jeder Messung geringfügig schwanken kann, ist die zum Startzeitpunkt t₀ des zweiten Signalabschnitts II gemessene Phase ϕ_{E}(t₀) des Antwortsignals e(t) wie auch der gesamte gemessene Phasenverlauf ϕ_{E}(t) des Antwortsignals e(t) in Relation zu einer vorher festgelegten Bezugsphase ϕ_{ERef}(t₀) zum Startzeitpunkt t₀ des zweiten Signalabschnitts II zu referenzieren. Über eine im nachfolgenden Verfahrensschritt S60 durchgeführte Phasenverschiebung des Phasenverlauf ϕ_{E}(t) des Antwortsignals e(t) in Höhe der Phasendifferenz zwischen der Phase ϕ_{E}(t₀) des Antwortsignals e(t) und der Bezugsphase ϕ_{ERef}(t₀) kann eine Phasensynchronisierung zwischen mehreren hintereinander gemessenen Antwortsignalen eᵢ(t) im zweiten Signalabschnitt II verwirklicht werden.

Schließlich ist der auf die Bezugsphase ϕ_{ERef}(t₀) referenzierte Phasenverlauf ϕ_{E}(t) des Antwortsignals e(t) im zweiten Signalabschnitt II im Hinblick auf einen im Verfahrensschritt S40 identifizierten Frequenzversatz Δf des Trägers im Rahmen der Frequenzsynchronisierung zu kompensieren. Der vom Frequenzversatz Δf des Trägers zwischen Eingang und Ausgang des Übertragungsgliedes 14 noch nicht kompensierte Phasenverlauf ϕ_{E}'(t) des Antwortsignals e(t) im Signalabschnitt II würde gemäß Fig. 4 zu einer zusätzlichen unerwünschten Phasendrift führen. Der vom Frequenzversatz Δf des Trägers zwischen Eingang und Ausgang des Übertragungsgliedes 14 kompensierte und damit phasendriftfreie Phasenverlauf ϕ_{E}(t) des Antwortsignals e(t) im Signalabschnitt II ist ebenfalls in Fig. 4 dargestellt.

In Verfahrensschritt S60 erfolgt schließlich die kohärente Mittelung der bei mehrmaliger Beaufschlagung des Übertragungsgliedes 14 mit einem Zufalls-Testsignal s(t) jeweils vom Meßgerät 12 gemessenen Verlaufs der Inphase- und Quadraturkomponente I_{Ei}(t) und Q_{Ei}(t) des Antwortsignals eᵢ(t), bevor aus dem gemittelten Verlauf der Inphase- und Quadraturkomponente des Antwortsignals e(t) der Amplituden- und Phasenverlauf |e(t)| und ϕ_{E}(t) des Antwortsignals e(t) im Signalabschnitt II ermittelt wird. Durch die Mittelung wird der Signal-Rausch-Abstand des Inphase- und Quadraturkomponentenverlaufs I_{E}(t) und Q_{E}(t) und damit des Amplituden- und Phasenverlaufs |e(t)| und ϕ_{E}(t) des Antwortsignals e(t) im Signalabschnitt II minimiert. Der gemittelte Inphasekomponentenverlauf I_{E}(t) des Antwortsignals e(t) im Signalabschnitt II ergibt sich aus den jeweils zueinander phasensynchronisierten Inphasekomponentenverlauf I_{Ei}(t) des Antwortsignals eᵢ(t). Der gemittelte Quadraturkomponentenverlauf Q_{E}(t) des Antwortsignals e(t) im Signalabschnitt II ergibt sich aus den jeweils zueinander phasensynchronisierten Quadraturkomponentenverlauf Q_{Ei}(t) des Antwortsignals eᵢ(t).

Schließlich erfolgt in Verfahrensschritt S70 durch die Einheit zur übergeordneten Ablaufsteuerung 13 die Ermittlung der Amplituden- und Phasen-Kennlinie des Übertragungsgliedes 14 aus dem vorher festgelegten Amplitudenverlauf |s(t)| und Phasenverlauf ϕ_{S}(t) des Testsignals s(t) im Signalabschnitt II, die der Sende-Einheit 15 über die Verbindungsleitung 18 kommuniziert wird, und dem gemittelten Amplitudenverlauf |e(t)| und Phasenverlauf ϕ_{E}(t) des Antwortsignals e(t) im Signalabschnitt II, die der Einheit zur übergeordneten Ablaufsteuerung 13 vom Meßgerät 12 über die Verbindungsleitung 19 kommuniziert wird. Für die Ermittlung der AM-AM-Charakteristik des Übertragungsgliedes wird der gemessene Amplitudenverlauf |e(t)| des Antwortsignals e(t) in Abhängigkeit vom erzeugten Amplitudenverlauf |s(t)| des Testsignals s(t) dargestellt. Für die Ermittlung der AM-PM-Charakteristik des Übertragungsgliedes wird die Phasendifferenzverlauf zwischen dem gemittelten Phasenverlauf ϕ_{E}(t) des Antwortsignals e(t) und dem erzeugten Phasenverlauf ϕ_{S}(t) des Testsignals s(t) in Abhängigkeit vom erzeugten Amplitudenverlauf |s(t)| des Testsignals s(t) dargestellt.

Der Erfindung ist nicht auf die dargestellte Ausführungsform beschränkt. Insbesondere sind die Vermessung anderer nachrichtentechnischer Übertragungsglieder, z. B. Filter, Mischer usw. und andere Übertragungssignale nach anderen Modulations-Verfahren und -Standards von der Erfindung abgedeckt.

## Patentansprüche

1. Verfahren zur Ermittlung der Amplitude und/oder der Phase eines Ausgangssignals eines Übertragungsgliedes (14) in Abhängigkeit der Amplitude eines Eingangssignals (AM-AM- und/oder AM-PM-Kennlinie) mit folgenden Verfahrensschritten:
• Schätzen eines Zeitversatzes (Δt) und eines Frequenzversatzes (Δf) zwischen einem bekannten, von einer Einheit zur übergeordneten Ablaufsteuerung (13) vorgegebenen, am Eingang des Übertragungsgliedes (14) durch eine Sende-Einheit (15) erzeugten Testsignal (s(t)) und einem durch Amplitudenverzerrung und/oder Phasenverzerrung im Übertragungsglied (14) hervorgegangenen Antwortsignal (e(t)) zur Zeit- und Frequenzsynchronisierung des Antwortsignal (e(t)) zum Testsignal (s(t)) in einem ersten Signalabschnitt (I),
• Bestimmen eines Startzeitpunkts (t₀) eines an den ersten Signalabschnitt (I) zeitlich anschließenden zweiten Signalabschnitts (II), in dem die AM-AM- und/oder die AM-PM-Kennlinie des Übertragungsgliedes (14) ermittelt wird, und einer Phase (ϕ_{E}(t₀)) eines Phasenverlaufs (ϕ_{E}(t)) des Antwortsignals (e(t)) zum Startzeitpunkt (t₀), die zu einer vorher festgelegten Bezugsphase (ϕ_{EREF}(t₀)) referenziert wird, zur Phasensynchronisierung des Antwortsignals (e(t)) zum Testsignal (s(t)),
• Erzeugen des bekannten Testsignals (s(t)) und Messen und Mitteln eines Amplitudenverlaufs (|e(t)|) und/oder des Phasenverlaufs (ϕ_{E}(t)) des Antwortsignals (e(t)) am Ausgang des Übertragungsgliedes (14) und Kommunikation an die Einheit zur übergeordneten Ablaufsteuerung (13) durch ein Messgerät (12) im zweiten Signalabschnitt (II) und
• Ermitteln der AM-AM-Kennlinie als vom erzeugten Amplitudenverlauf (|s(t)|) des Testsignals (s(t)) abhängigen, gemessenen Amplitudenverlauf (|e(t)|) des Antwortsignals (e(t)) und der AM-PM-Kennlinie als vom erzeugten Amplitudenverlauf (|s(t)|) des Testsignals (s(t)) abhängigen Phasendifferenzverlauf zwischen dem gemittelten Phasenverlauf (ϕ_{E}(t)) des Antwortsignals (e(t)) und dem Phasenverlauf (ϕ_{S}(t)) des Testsignals (s(t)).

2. Verfahren zur Ermittlung der Amplituden- und/oder Phasen-Charakteristik eines Übertragungsgliedes nach Anspruch 1,
**dadurch gekennzeichnet,**
**dass** für die Schätzung im ersten Signalabschnitt (I) des Testsignals (s(t)) bzw. Antwortsignals (e(t)) ein Burstsignal verwendet wird.

3. Verfahren zur Ermittlung der Amplituden- und/oder Phasen-Charakteristik eines Übertragungsgliedes nach Anspruch 2,
**dadurch gekennzeichnet,**
**dass** das Burstsignal ein Burstsignal nach dem GSM-Standard ist.

4. Verfahren zur Ermittlung der Amplituden- und/oder Phasen-Charakteristik eines Übertragungsgliedes nach Anspruch 2 oder 3,
**dadurch gekennzeichnet,**
**dass** die Schätzung über eine Modulations-Analyse des Burstsignals erfolgt.

5. Verfahren zur Ermittlung der Amplituden- und/oder Phasen-Charakteristik eines Übertragungsgliedes nach einem der Ansprüche 1 bis 4,
**dadurch gekennzeichnet,**
**dass** die Zeitsynchronisierung des Antwortsignals (e(t)) zum Testsignal (s(t)) eine Bestimmung des Startzeitpunkts (t₀) des zweiten Signalabschnitt (II) des Antwortsignals (e(t)) im ersten Signalabschnitt (I) beinhaltet.

6. Verfahren zur Ermittlung der Amplituden- und/oder Phasen-Charakteristik eines Übertragungsgliedes nach einem der Ansprüche 1 bis 5,
**dadurch gekennzeichnet,**
**dass** die Frequenzsynchronisierung zwischen Testsignal (s(t)) und Antwortsignal (e(t)) eine Bestimmung des Frequenzversatzes (Δf) eines Trägersignals zwischen Eingang und Ausgang des Übertragungsgliedes (14) im ersten Signalabschnitt (I) zur Kompensierung der durch den Frequenzversatz (Δf) zwischen Testsignal (s(t)) und Antwortsignal (e(t)) verursachten Phasendrift im Phasenverlauf (ϕ_{E}'(t)) im zweiten Signalabschnitt (II) des Antwortsignals (e(t)) beinhaltet.

7. Verfahren zur Ermittlung der Amplituden- und/oder Phasen-Charakteristik eines Übertragungsgliedes nach einem der Ansprüche 1 bis 6,
**dadurch gekennzeichnet,**
**dass** die Phasensynchronisierung zusätzlich eine Mittelung mehrerer Antwortsignale (eᵢ(t)), die jeweils aus einer Beaufschlagung des Übertragungsgliedes (14) mit einem identischen Testsignal (s(t)) resultieren, beinhaltet.

8. Verfahren zur Ermittlung der Amplituden- und/oder Phasen-Charakteristik eines Übertragungsgliedes nach Anspruch 7,
**dadurch gekennzeichnet,**
**dass** die Mittelung eine kohärente Mittelung ist, in der die einzelnen gemessenen Antwortsignale (eᵢ(t)) phasensynchron zueinander gemittelt werden, indem die jeweils zueinander phasensynchronisierten Inphasekomponentenverläufe (I_{Ei}(t)) des Antwortsignals (eᵢ(t)) und die jeweils zueinander phasensynchronisierten Quadraturkomponentenverläufe (Q_{Ei}(t)) des Antwortsignals (eᵢ(t)) im zweiten Signalabschnitt (II) ermittelt werden.

9. Verfahren zur Ermittlung der Amplituden- und/oder Phasen-Charakteristik eines Übertragungsgliedes nach Anspruch 8,
**dadurch gekennzeichnet,**
**dass** die phasensynchrone Mittelung der einzelnen gemessenen Antwortsignale (eᵢ(t)) durch eine Phasenverschiebung der Phasenverläufe (ϕ_{Ei}(t)) des jeweils gemessenen Antwortsignals (eᵢ(t)) in Höhe der Phasendifferenz zwischen der Phase (ϕ_{Ei}(t₀) des Antwortsignals (eᵢ(t)) zum Startzeitpunkt (t₀) des zweiten Signalabschnitts (II) und der vorher festgelegten Bezugsphase (ϕ_{ERef}(t₀)) erfolgt.

10. System zur Ermittlung der Amplitude und/oder der Phase eines Ausgangssignals eines Übertragungsgliedes (14) in Abhängigkeit der Amplitude eines Eingangssignals (AM-AM- und/oder AM-PM-Kennlinie) in einem zweiten Signalabschnitt (II) bestehend aus
einer Serienschaltung mit einer Sende-Einheit (15) zur Erzeugung eines Testsignals (s(t)) am Eingang des Übertragungsgliedes (14),
dem Übertragungsglied (14), das von dem von der Sende-Einheit (15) generierten Testsignal (s(t)) beaufschlagt wird, und
einem Messgerät (12) zur einzigen Messung und Mittelung eines Amplitudenverlaufs (|e(t)|) und/oder eines Phasenverlaufs (ϕ_{E}(t)) eines aus dem Testsignal (s(t)) durch Amplituden- und/oder Phasenverzerrung im Übertragungsglied (14) hervorgegangenen Antwortsignals (e(t)) und zur Kommunikation des gemessenen und gemittelten Amplitudenverlaufs (|e(t)|) und/oder des gemessenen und gemittelten Phasenverlaufs (ϕ_{E}(t)) des Antwortsignals (e(t)) an eine Einheit zur übergeordneten Ablaufsteuerung (14),
wobei die Einheit zur übergeordneten Ablaufsteuerung (14) das bekannte Testsignal (s(t)) der Sende-Einheit (15) vorgibt und die AM-AM-Kennlinie des Übertragungsgliedes (14) als vom erzeugten Amplitudenverlauf (|s(t)|) des Testsignals (s(t)) abhängigen, gemessenen Amplitudenverlauf (|e(t)|) des Antwortsignals (e(t)) und/oder die AM-PM-Kennlinie des Übertragungsgliedes (14) als vom erzeugten Amplitudenverlauf (|s(t)|) des Testsignals (s(t)) abhängigen Phasendifferenzverlauf zwischen dem gemittelten Phasenverlauf (ϕ_{E}(t)) des Antwortsignals (e(t)) und dem Phasenverlauf (ϕ_{S}(t)) des Testsignals (s(t)) ermittelt, und
wobei zur Phasensynchronisierung des Antwortsignals (e(t)) zum Testsignal (s(t)) in einem dem zweiten Signalabschnitt (II) zeitlich vorausgehenden ersten Signalabschnitt (I) ein Bestimmen eines Startzeitpunkts (t₀) des zweiten Signalabschnitts (II), in dem die AM-AM- und/oder die AM-PM-Kennlinie des Übertragungsgliedes (14) ermittelt wird, und einer Phase (ϕ_{E}(t₀)) eines Phasenverlaufs (ϕ_{E}(t)) des Antwortsignals (e(t)) zum Startzeitpunkt ((t₀)), die zu einer vorher festgelegten Bezugsphase (ϕ_{EREF}(t₀)) referenziert wird, durch das Messgerät (12) erfolgt.

## Claims

1. Method for determining the amplitude and/or the phase of an output signal of a transmission element (14) dependent upon the amplitude of an input signal (AM-AM- and/or AM-PM characteristic) with the following procedural stages:
- estimation of a time offset (Δt) and a frequency offset (Δf) between a known test signal (s(t)) specified by a unit for superordinate procedural control (13), generated at the input of the transmission element (14) by a transmission unit (15), and a response signal (e(t)) resulting from amplitude distortion and/or phase distortion in the transmission element (14), for the time synchronisation and frequency synchronisation of the response signal (e(t)) relative to the test signal (s(t)) within a first signal segment (I);
- determination of a start timing point (t₀) of a second signal segment (II) adjacent in time to the first signal segment (I), in which the AM-AM characteristic and/or AM-PM characteristic of the transmission element (14) is determined, and of a phase (ϕ_{E}(t₀)) of a phase characteristic (ϕ_{E}(t)) of the response signal (e(t)) at the start timing point (to), which is referenced to a previously-determined reference phase (ϕ_{EREF}(t₀)), for the phase synchronisation of the response signal (e(t)) relative to the test signal (s(t));
- generation of the known test signal (s(t)) and measurement and averaging of an amplitude characteristic (|e(t)|) and/or of the phase characteristic (ϕ_{E}(t)) of the response signal (e(t)) at the output of the transmission element (14) and communication to the unit for superordinate procedural control (13) by a measuring device (12) in the second signal segment (II); and
- determination of the AM-AM characteristic as the measured amplitude characteristic (|e(t)|) of the response signal (e(t)) dependent upon the generated amplitude characteristic (|s(t)|) of the test signal (s(t)), and of the AM-PM characteristic as the phase-difference characteristic between the averaged phase characteristic (ϕ_{E}(t)) of the response signal (e(t)) and the phase characteristic (ϕ_{S}(t)) of the test signal (s(t)) dependent upon the generated amplitude characteristic (|s(t)|) of the test signal (s(t)).

2. Method for determining the amplitude and/or phase characteristic of a transmission element according to claim 1,
**characterised in that**
a burst signal is used for the estimation in the first signal segment (I) of the test signal (s(t)) or respectively response signal (e(t)).

3. Method for determining the amplitude and/or phase characteristic of a transmission element according to claim 2,
**characterised in that**
the burst signal is a burst signal according to the GSM standard.

4. Method for determining the amplitude and/or phase characteristic of a transmission element according to claim 2 or 3,
**characterised in that**
the estimation is implemented via a modulation analysis of the burst signal.

5. Method for determining the amplitude and/or phase characteristic of a transmission element according to claims 1 to 4,
**characterised in that**
the time synchronisation of the response signal (e(t)) relative to the test signal (s(t)) contains a determination of the start timing point (t₀) of the second signal segment (II) of the response signal (e(t)) in the first signal segment (I).

6. Method for determining the amplitude and/or phase characteristic of a transmission element according to any one of claims 1 to 5,
**characterised in that**
the frequency synchronisation between test signal (s(t)) and response signal (e(t)) contains a determination of the frequency offset (Δf) of a carrier signal between input and output of the transmission element (14) in the first signal segment (I) for the compensation of the phase drift caused by the frequency offset (Δf) between test signal (s(t)) and response signal (e(t)) in the phase characteristic (ϕ_{E}'(t)) in the second signal segment (II) of the response signal (e(t)).

7. Method for determining the amplitude and/or phase characteristic of a transmission element according to any one of claims 1 to 6,
**characterised in that**
the phase synchronisation additionally contains an averaging of several response signals (eᵢ(t)), each of which results from a supplying of the transmission element (14) with an identical test signal (s(t)).

8. Method for determining the amplitude and/or phase characteristic of a transmission element according to claim 7,
**characterised in that**
the averaging is a coherent averaging, in which the individual measured response signals (eᵢ(t)) are averaged with one another in a phase-synchronous manner by determining the respective, mutually phase-synchronised in-phase-component characteristics (I_{Ei}(t)) of the response signal (eᵢ(t)) and the respective, mutually phase-synchronised quadrature-component characteristics (Q_{Ei}(t)) of the response signal (eᵢ(t)) in the second signal segment (II).

9. Method for determining the amplitude and/or phase characteristic of a transmission element according to claim 8,
**characterised in that**
the phase-synchronous averaging of the individual measured response signals (eᵢ(t)) is implemented through a phase displacement of the phase characteristics (ϕ_{Ei}(t)) of the respectively-measured response signal (eᵢ(t)) at the level of the phase difference between the phase (ϕ_{Ei}(t₀)) of the response signal (eᵢ(t)) relative to the start timing point (t₀) of the second signal segment (II) and the previously-determined reference phase (ϕ_{ERef}(t₀)).

10. System for determining the amplitude and/or phase of an output signal of a transmission element (14) dependent upon the amplitude of an input signal (AM-AM and/or AM-PM characteristic) in a second signal segment (II) consisting of:
a series circuit with a transmission unit (15) for the generation of a test signal (s(t)) at the input of the transmission element (14),
the transmission element (14), which is supplied from the test signal (s(t)) generated by the transmission unit (15), and
a measuring device (12) for the single measurement and averaging of an amplitude characteristic (|e(t)|) and/or a phase characteristic (ϕ_{E}(t)) of a response signal (e(t)) originating from the test signal (s(t)) through amplitude and/or phase distortion in the transmission element (14) and for the communication of the measured and averaged amplitude characteristic (|e(t)|) and/or of the measured and averaged phase characteristic (ϕ_{E}(t)) of the response signal (e(t)) to a unit for superordinate procedural control (14), wherein the unit for superordinate procedural control (14) specifies the known test signal (s(t)) to the transmission unit (15) and determines the AM-AM characteristic of the transmission element (14) as a measured amplitude characteristic (|e(t)|) of the response signal (e(t)) dependent upon the generated amplitude characteristic (|s(t)|) of the test signal (s(t)) and/or the AM-PM characteristic of the transmission element (14) as the phase-difference characteristic between the averaged phase characteristic (ϕ_{E}(t)) of the response signal (e(t)) and the phase characteristic (ϕ_{S}(t)) of the test signal (s(t)) dependent upon the generated amplitude characteristic (|s(t)|) of the test signal (s(t)), and
wherein for the phase synchronisation of the response signal (e(t)) relative to the test signal (s(t)), in a first signal segment (I) preceding the second signal segment (II) in time, a determination of a start timing point (t₀) of the second signal segment (II), in which the AM-AM and/or the AM-PM characteristic of the transmission element (14) is determined, and of a phase (ϕ_{E}(t₀)) of a phase characteristic (ϕ_{E}(t)) of the response signal (e(t)) at the start timing point (to), which is referenced to the previously-determined reference phase (ϕ_{ERef}(t₀)), is implemented by the measuring device (12).

## Revendications

1. Procédé pour déterminer l'amplitude et/ou la phase d'un signal de sortie d'un élément de transmission (14) en fonction de l'amplitude d'un signal d'entrée (courbe caractéristique AM-AM et/ou AM-PM) comprenant les étapes suivantes :
- estimer un décalage temporel (Δt) et un décalage fréquentiel (Δf) entre un signal de test (s(t)) connu, fixé à l'avance par une unité de commande séquentielle surjacente (13) et produit par une unité émettrice (15) à l'entrée de l'élément de transmission (14), et un signal de réponse (e(t)) résultant d'une distorsion d'amplitude et/ou d'une distorsion de phase dans l'élément de transmission (14), pour la synchronisation temporelle et fréquentielle du signal de réponse (e(t)) au signal de test (s(t)) dans une première partie de signal (I),
- déterminer un point de départ (t₀) d'une seconde partie de signal (II) suivant la première partie de signal (I), où la courbe caractéristique AM-AM et/ou AM-PM de l'élément de transmission (14) est déterminée, et une phase (ϕ_{E}(t₀)) d'une (variation) de phase (ϕ_{E}(t)) du signal de réponse (e(t)) au point de départ (t₀), laquelle est référencée à une phase de référence (ϕ_{EREF}(t₀)) fixée à l'avance, pour la synchronisation de phase du signal de réponse (e(t)) au signal de test (s(t)),
- produire le signal de test (s(t)) connu et mesurer et moyenner une variation d'amplitude (|e(t)|) et/ou la variation de phase (ϕ_{E}(t)) du signal de réponse (e(t)) à la sortie de l'élément de transmission (14) et le communiquer à l'unité de commande séquentielle surjacente (13) par un appareil de mesure (12) dans la seconde partie de signal (II), et
- déterminer la courbe caractéristique AM-AM en tant que variation d'amplitude (|e(t)|) mesurée du signal de réponse (e(t)), dépendant de la variation d'amplitude (|s(t)|) produite du signal de test (s(t)), et la courbe caractéristique AM-PM en tant que variation de différence de phase entre la variation de phase moyennée (ϕ_{E}(t)) du signal de réponse (e(t)) et la variation de phase (ϕ_{S}(t)) du signal de test (s(t)), dépendant de la variation d'amplitude (|s(t)|) produite du signal de test (s(t)).

2. Procédé pour déterminer la caractéristique d'amplitude et/ou de phase d'un élément de transmission selon la revendication 1,
**caractérisé en ce que**, pour l'estimation dans la première partie de signal (I) du signal de test (s(t)) respectivement du signal de réponse (e(t)), on utilise un signal de salve.

3. Procédé pour déterminer la caractéristique d'amplitude et/ou de phase d'un élément de transmission selon la revendication 2,
**caractérisé en ce que** le signal de salve est un signal de salve selon la norme GSM.

4. Procédé pour déterminer la caractéristique d'amplitude et/ou de phase d'un élément de transmission selon la revendication 2 ou 3,
**caractérisé en ce que** l'estimation est effectuée par une analyse de modulation du signal de salve.

5. Procédé pour déterminer la caractéristique d'amplitude et/ou de phase d'un élément de transmission selon l'une quelconque des revendications 1 à 4,
**caractérisé en ce que** la synchronisation temporelle du signal de réponse (e(t)) au signal de test (s(t)) comprend une détermination du point de départ (t₀) de la seconde partie de signal (II) du signal de réponse (e(t)) dans la première partie de signal (I).

6. Procédé pour déterminer la caractéristique d'amplitude et/ou de phase d'un élément de transmission selon l'une quelconque des revendications 1 à 5,
**caractérisé en ce que** la synchronisation de fréquence entre le signal de test (s(t)) et le signal de réponse (e(t)) comprend une détermination du décalage fréquentiel (Δf) d'un signal porteur entre l'entrée et la sortie de l'élément de transmission (14) dans la première partie de signal (I), pour compenser le glissement de phase causé par le décalage fréquentiel (Δf) entre le signal de test (s(t)) et le signal de réponse (e(t)) dans la variation de phase (ϕ_{E'}(t)) dans la seconde partie de signal (II) du signal de réponse (e(t)).

7. Procédé pour à déterminer la caractéristique d'amplitude et/ou de phase d'un élément de transmission selon l'une quelconque des revendications 1 à 6,
**caractérisé en ce que** la synchronisation de phase comprend, de plus, l'étape consistant à effectuer une moyenne de plusieurs signaux de réponse (eᵢ(t)), lesquels résultent d'une alimentation de l'élément de transmission (14) avec un signal de test (s(t)) identique.

8. Procédé pour déterminer la caractéristique d'amplitude et/ou de phase d'un élément de transmission selon la revendication 7,
**caractérisé en ce que** ladite moyenne est une moyenne cohérente, où les signaux de réponse (eᵢ(t)) mesurés individuels sont moyennés ensemble en synchronisation de phase, dans la mesure où les variations des composantes de phase (I_{Ei}(t)) synchronisées en phase les unes avec les autres du signal de réponse (eᵢ(t)) et les variations des composantes de quadrature (Q_{Ei}(t)) synchronisées en phase les unes avec les autres du signal de réponse (eᵢ(t)) sont déterminées dans la seconde partie de signal (II).

9. Procédé pour déterminer la caractéristique d'amplitude et/ou de phase d'un élément de transmission selon la revendication 8,
**caractérisé en ce que** la moyenne synchronisée en phase des signaux de réponse (eᵢ(t)) mesurés individuels est réalisée par un déphasage des variations de phase (ϕ_{Ei}(t)) du signal de réponse mesuré (eᵢ(t)) à hauteur de la différence de phase entre la phase (ϕ_{Ei}(t₀)) du signal de réponse (eᵢ(t)) au point de départ (t₀) de la seconde partie de signal (II) et une phase de référence (ϕ_{EREF}(t₀)) fixée à l'avance.

10. Système pour déterminer l'amplitude et/ou la phase d'un signal de sortie d'un élément de transmission (14) en fonction de l'amplitude d'un signal d'entrée (courbe caractéristique AM-AM et/ou AM-PM) dans une seconde partie de signal (II) constitué
d'un montage en série comportant une unité émettrice (15) pour produire un signal de test (s(t)) à l'entrée de l'élément de transmission (14),
l'élément de transmission (14), lequel est alimenté par le signal de test (s(t)) généré par l'unité émettrice (15), et
un appareil de mesure (12), pour mesurer et moyenner uniquement une variation d'amplitude (|e(t)|) et/ou une variation de phase (ϕ_{E}(t)) d'un signal de réponse qui résulte du signal de test (s(t)) par décalage d'amplitude et/ou de phase dans l'élément de transmission, et pour communiquer la variation d'amplitude (|e(t)|) mesurée et moyennée et/ou la variation de phase (ϕ_{E}(t)) mesurée et moyennée du signal de réponse (e(t)) à une unité de commande séquentielle surjacente (14),
dans lequel l'unité de commande séquentielle surjacente (14) fixe à l'avance le signal de test connu (s(t)) de l'unité émettrice (15) et détermine la courbe caractéristique AM-AM de l'élément de transmission (14), en tant que variation d'amplitude mesurée (|e(t)|) du signal de réponse (e(t)) dépendant de la variation d'amplitude produite (|s(t)|) du signal de test (s(t)), et/ou la courbe caractéristique AM-PM de l'élément de transmission (14) en tant que variation de différence de phase entre la variation de phase moyennée (ϕ_{E}(t)) du signal de réponse (e(t)) et la variation de phase (ϕ_{S}(t)) du signal de test (s(t)) dépendant de la variation d'amplitude (|(s(t)|) produite du signal de mire (s(t)), et
dans lequel, pour synchroniser la phase du signal de réponse (e(t)) au signal de test (s(t)) dans la première partie de signal (I) précédant la seconde partie de signal (II), une détermination d'un point de départ (t₀) de la seconde partie de signal (II), où la courbe caractéristique AM-AM et/ou AM-PM de l'élément de transmission (14) est déterminée, et une phase (ϕ_{E}(t₀)) d'une variation de phase (ϕ_{E}(t)) du signal de réponse (e(t)) au point de départ ((t₀)), qui est référencée à une phase de référence (ϕ_{EREF}(t₀)) fixée à l'avance, est réalisé par l'appareil de mesure (12).
